# EUROPÄISCHE PATENTSCHRIFT

(11) **EP 3 516 688 B1**
(45) Veröffentlichungstag und Bekanntmachung des Hinweises auf die Patenterteilung: **01.04.2020**
(21) Anmeldenummer: 17764319.4
(22) Anmeldetag: 22.08.2017
(51) Int. Cl.: H01L 25/16, H01L 33/48, H05K 1/18, H05K 3/34, F21Y 107/50, F21Y 115/10, F21S 41/147, F21S 41/19, F21S 41/25, F21S 41/32, H01L 33/62

(54) **KRAFTFAHRZEUG-SCHEINWERFER MIT EINER AUFGELÖTETEN SMD-LED**
MOTOR-VEHICLE HEADLAMP HAVING AN SMD LED ATTACHED BY SOLDERING
PHARE DE VÉHICULE À MOTEUR AVEC DEL SMD SOUDÉE

(30) Priorität: 21.09.2016 AT 508462016
(43) Veröffentlichungstag der Anmeldung: 31.07.2019
(73) Patentinhaber: ZKW Group GmbH, 3250 Wieselburg (AT)
(72) Erfinder: PETSCH, Daniel, 3292 Gaming (AT)
(74) Vertreter: Patentanwaltskanzlei Matschnig & Forsthuber OG
(86) Internationale Anmeldenummer: PCT/AT2017/060207
(87) Internationale Veröffentlichungsnummer: WO 2018/053562

(56) Entgegenhaltungen:
- EP-A1- 3 119 168
- EP-A2- 2 357 398
- WO-A1-2011/114270
- WO-A1-2012/084481
- DE-A1-102014 107 130
- FR-A1- 2 858 681
- US-A- 5 119 240
- US-A1- 2004 070 990
- US-A1- 2006 126 353
- US-A1- 2012 293 721

## Beschreibung

Die Erfindung bezieht sich auf ein Verfahren zur gezielten Einstellung der Abstrahlrichtung zumindest einer LED bei einem Kraftfahrzeug-Scheinwerfer mit zumindest einer auf metallischen Flächen einer Leiterplatte mit ihren Anschlüssen als SMD aufgelöteten LED, sowie mit einer Optik, welche das von der zumindest einen LED abgestrahlte Licht in den Verkehrsraum abstrahlt.

Ein Problem bei Scheinwerfern der gegenständlichen Art liegt darin, dass eine LED als solche zwar eine sehr kleine Abstrahlfläche aufweist, in der Praxis jedoch eine Leiterplatte benötigt, auf welcher sie durch Löten mit stromführenden Leiterbahnen verbunden ist. Im Rahmen der vorliegenden Erfindung sind die LEDs als SMD-Bauelemente (**S**urface **M**ounted **D**evice) ausgebildet, die mit ihren elektrischen Anschlüssen, meist kurz "Pads" genannt, direkt auf die Leiterplatte aufgelötet sind, wobei ein Reflow-Verfahren angewandt wird. Vor allem aber wird die Leiterplatte, meist zusammen mit auf dieser angeordneten Kühlelementen zur Kühlung der LED oder LEDs benötigt, denn das Fehlen einer geeigneten Kühlung würde bei den im Scheinwerferbereich verwendeten Hochleistungs-LEDs zu deren Zerstörung, auf jeden Fall aber zu einer unerträglichen Verminderung ihrer Lebensdauer führen.

Die Leiterplatte stellt jedoch in dem Scheinwerfer für dessen optisches System ein Problem dar, da die darauf aufgelötete LED bzw. aufgelöteten LEDs parallel zur Leiterplattenebene liegen und ohne besondere Vorkehrungen nicht hinsichtlich ihrer Abstrahlrichtung justierbar sind. Dies führt dazu, dass ein Teil des von der LED oder den LEDs abgestrahlten Lichts ungenutzt bleibt und/oder bei Verwendung eines Reflektors im Scheinwerfer die Leiterplatte einen Teil des von dem Reflektor abgestrahlten Lichts abschatten kann.

An dieser Stelle ist weiters anzumerken, dass LEDs im Gegensatz zu vielen anderen konventionellen Leuchtmitteln nur einen begrenzten Öffnungswinkel besitzen und somit bezogen auf eine Kugeloberfläche in einen Teilwinkel strahlen, sodass man optische Systeme, die beispielsweise für Glühlampen geeignet sind, nicht kritiklos übernehmen kann und sich spezifische Probleme, auf die weiter unten noch eingegangen wird, ergeben, welche den Gesamtwirkungsgrad herabsetzen.

Aus den Druckschriften WO 2011099328 A1, US 2014319200 A1 und CN 201708701 U gehen jeweils SMD-LEDs hervor, welche auf Grund unterschiedlicher Lotdicken nicht mehr parallel zu einer Leiterplatte angeordnet sind. Vielmehr sind die LEDS gezielt geneigt, um gewünschte Abstrahlrichtungen zu erreichen. Die zugehörigen technischen Gebiete betreffen jedoch Hintergrundbeleuchtungen für LCDs, einen Bilddichtedetektor bzw. eine LED-Leuchtröhre, nicht jedoch das Gebiet des Kraftfahrzeugscheinwerferbaus und beinhalten auch keine zusätzlichen, den LEDs nachgeordnete Optiken, zur Abstrahlung des LED-Lichts in den Verkehrsraum.

Aus der Druckschrift US 2004/0070990 A1 und aus der nachveröffentlichen Druckschrift EP 3 119 168 A1 sind Verfahren zur Positionierung einer Leuchtdiode mit einem Winkel zur Leiterplatte offenbart.

Eine Aufgabe der Erfindung liegt darin, die genannten Nachteile möglichst ohne zusätzliche Kosten zu beseitigen und dadurch insgesamt den Wirkungsgrad des Scheinwerfers zu erhöhen.

Diese Aufgabe wird, ausgehend von einem Verfahren der eingangs genannten Art, erfindungsgemäß dadurch gelöst, dass zur gezielten Einstellung der Abstrahlrichtung der zumindest einen LED diese mit unterschiedlichen Lotdicken zwischen ihren Anschlüssen und den metallischen Flächen der Leiterplatte aufgelötet ist, indem das Verfahren gemäß Anspruch 1 verwendet wird.

Die Erfindung ermöglicht ein "Justieren" der Abstrahlrichtung einer oder mehrerer LEDs und damit eine optimale Nutzung des von den LEDs angestrahlten Lichtes, ohne dass de facto zusätzliche Kosten erwachsen.

Bei einer zweckmäßigen Variante der Erfindung kann vorgesehen sein, dass die Optik als Linsensystem ausgebildet ist, das zumindest eine Linse aufweist und eine Leiterplatte mit zumindest zwei LEDs, die in Abstand von einer Linse annähernd normal zur optischen Achse angeordnet ist, wobei außerhalb der optischen Achse liegende LEDs mit unterschiedlichen Lotdicken zwischen ihren Anschlüssen und den metallischen Flächen der Leiterplatte so angeordnet sind, dass ihre Hauptabstrahlrichtung zum Zentrum der Linse gerichtet ist.

Auf diese Weise kann das Licht von außerhalb der optischen Achse platzierten LEDs, die nun zur optischen Achse geneigt sind, besser genutzt und der Gesamtwirkungsgrad erhöht werden.

Eine weitere zweckmäßige Variante zeichnet sich dadurch aus, dass die Optik als Reflektoroptik ausgebildet ist und einen Halbschalen-Reflektor aufweist, wobei die Leiterplatte mit der zumindest einen LED im Wesentlichen in der Schnittebene, welche auch die optische Achse enthält, liegt, wobei die zumindest eine LED mit unterschiedlichen Lotdicken zwischen ihren Anschlüssen und den metallischen Flächen der Leiterplatte so angeordnet ist, dass ihre Hauptabstrahlrichtung zu dem Reflektor geneigt ist.

Dank dieser Ausbildung ist gleichfalls eine Erhöhung des Wirkungsgrades möglich und man vermeidet ein Abschatten des ausgesandten Lichtes durch die Leiterplatte.

Dabei ist es besonders vorteilhaft, wenn der Reflektor ein Paraboloid-Halbschalen-Reflektor ist.

In manchen Fällen kann sinnvollerweise vorgesehen sein, dass dem Reflektor zusätzlich ein Linsensystem mit zumindest einer Linse zugeordnet ist.

Die Erfindung samt weiterer Vorteile ist im Folgenden an Hand beispielsweiser Ausführungsformen näher erläutert, die in der Zeichnung veranschaulicht sind. In dieser zeigen
Fig. 1 einen Halbschalenreflektor eines Scheinwerfers nach dem Stand der Technik in einem schematischen Schnitt mit einer auf einer Leiterplatte angeordneten LED-Lichtquelle,
Fig. 2 eine Ansicht wie Fig. 1 jedoch mit einer geneigten Leiterplatte, auf welcher eine LED-Lichtquelle angeordnet ist,
Fig. 3 in einer Ansicht wie Fig. 1 bzw. 2 die prinzipielle Lösung nach der Erfindung,
Fig. 4a in einem Schnitt die Anordnung einer als SMD-Bauteil ausgeführten LED auf einem Leiterplattenabschnitt vor einem Reflow-Lötvorgang,
Fig. 4b in einer Ansicht wie Fig. 4a die endgültige erfindungsgemäße Anordnung der LED auf einem Leiterplattenabschnitt nach dem Reflow-Lötvorgang,
Fig. 5 ein Linse eines Scheinwerfers nach dem Stand der Technik in einem schematischen Schnitt mit vier auf einer Leiterplatte angeordneten LED-Lichtquellen und
Fig. 6 eine Ansicht wie Fig. 5 jedoch mit zwei erfindungsgemäß gegen die Leiterplatte geneigten LED-Lichtquellen.

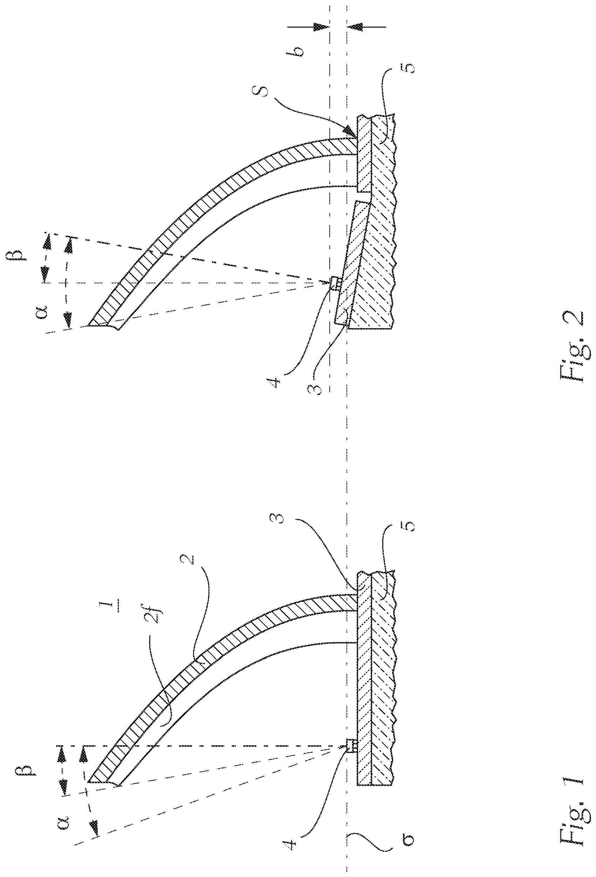

Bezug nehmend auf **Fig. 1** erkennt man einen Scheinwerfer 1 nach dem Stand der Technik mit einem Halbschalen-Reflektor **2** als Optik, bei welchem auf einer Leiterplatte **3** eine LED-Lichtquelle **4** angeordnet ist. Mit dem Bezugszeichen **5** ist ein Kühlkörper oder ein Teil des Gehäuses des Scheinwerfers 1 bezeichnet. Die Halbschale des Reflektors 2 ist bei einer Ausführungsform weniger ein Paraboloid als eine Aneinanderreihung von Facetten, die jedoch einer Paraboloidfläche entnommen sein könnten. Eine Facette ist im Schnitt gezeigt, bei einer benachbarten blickt man unter flachem Winkel auf die Reflektor-Innenfläche **2f**, die hier nur eine geringe Umschließung aufweist. Die Leiterplatte 3 mit der LED-Lichtquelle 4 liegt im Wesentlichen in der Schnittebene σ, welche auch die nicht näher bezeichnete optische Achse des Scheinwerfers 1 enthält. Die Reflektoröffnung befindet sich im Bereich des Brennpunkts bzw. des Ortes der Lichtquelle 4. Vom Halbraum in Lichtaustrittsrichtung des Reflektors treffen bei diesem Beispiel nur Strahlen in einem Winkel β von ca. 10° gemessen von der Hauptabstrahlrichtung der LED mit einem Gesamtabstrahlungswinkel von größer als α auf die Reflektor-Innenfläche 2f.

Man kann nun, wie **Fig. 2** zeigt, durch Neigen der Leiterplatte 3 mehr in Richtung des Inneren des Reflektors 2 versuchen, die Lichtausbeute zu erhöhen. Gezeigt ist eine um ca. 10° in Richtung des Parabelscheitels **S** geneigte Leiterplatte 3, so dass Strahlen in einem Winkel α bis 20°, gemessen von der Hauptabstrahlrichtung der LED, auf die Reflektor-Innenfläche 2f auftreffen. Allerdings hat dies zur Folge, dass nun ein Bereich der Reflektor-Innenfläche 2f nahe des Parabelscheitels S abgeschattet wird. In Fig. 2 ist dies der Bereich **b** zwischen den eingezeichneten strichpunktierten Linien. Diese Abschattung führt natürlich erneut zu Lichtverlusten und ist auch lichttechnisch unerwünscht.

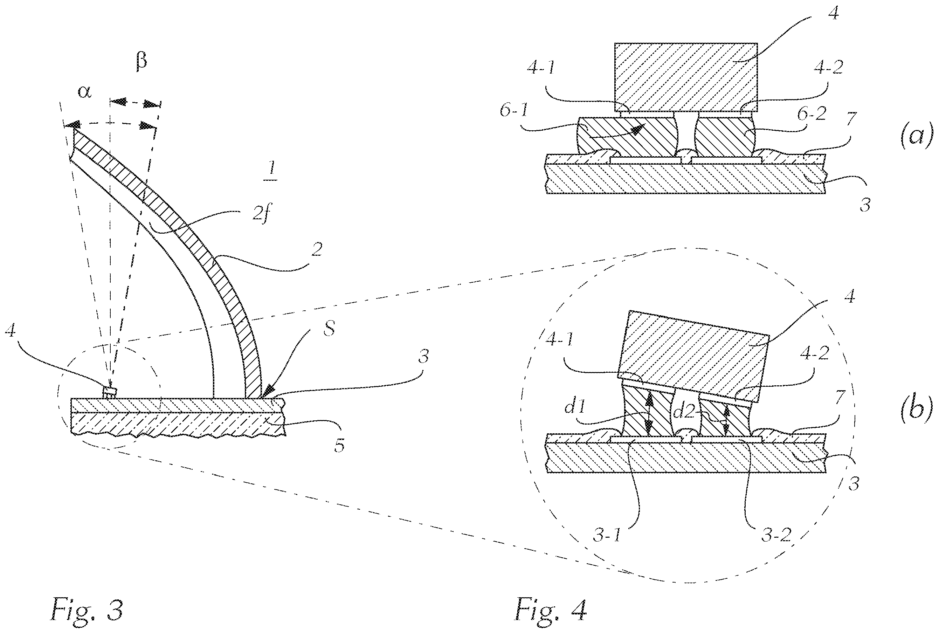

**Fig. 3** zeigt in Verbindung mit den **Fig. 4a** und **4b** die Problemlösung gemäß der Erfindung. Es ist nur die Lichtquelle, nämlich eine SMD-LED 4 um 10° gegen die Leiterplatte 3 geneigt, so dass Strahlen in einem Winkel α bis 20°, gemessen von der Hauptabstrahlrichtung, auf die Reflektorfläche auftreffen, ohne zusätzliche Teile der Reflektorfläche abzuschatten.

Um dies zu erreichen, wird zur gezielten Einstellung der Abstrahlrichtung der zumindest einen LED 4 diese mit unterschiedlichen Lotdicken zwischen ihren Anschlüssen und den metallischen Flächen der Leiterplatte aufgelötet. Dies wird nun an Hand der Fig. 4a und 4b im Detail erläutert.

Fig. 4b zeigt in einem stark vergrößertem Schnitt, bei welchem der Kühlkörper unter der Leiterplatte 3 weggelassen ist, dass die Neigung der SMD-LED 4 auf unterschiedlichen Lotdicken **d1**, **d2** bzw. unterschiedlich dicken Lotspalten zwischen den jeweiligen metallischen Flächen **3-1**, **3-2** der Leiterplatte 3 und der SMD-LED 4 beruht.

Fig. 4 a zeigt die bestückte LED 4 und das gedruckte Lot **6-1**, **6-2** vor dem Reflow-Prozess. Bei der dem Parabelscheitel S zugewandten Lötstelle befindet sich das Lot 6-2 nur innerhalb des von Lötstopplack **7** freigestellten Bereichs der metallischen Fläche 3-2 der Leiterplatte 3. Die genannten metallischen Flächen 3-1, 3-2 sind im Allgemeinen Lötaugen von Leiterbahnen. Bei jener Lötstelle, die der Reflektoröffnung zugewandt ist, befindet sich vor dem Reflow-Prozess das aufgedruckte Lot 6-1 zusätzlich zum von Lötstopplack 7 freigestellten Bereich der metallischen Fläche 3-1 auch auf dem Lötstopplack 7. Die Menge an Lot 6-1 an dieser metallischen Fläche 3-1 ist so bemessen, dass sich nach dem Sammeln des Lots auf der freigestellten metallischen Flächen 3-1 eine Höhe des Lötspalts d1 einstellt, die größer ist als bei der metallischen Fläche 3-2, die dem Parabelscheitel S zugewandt ist.

Die unterschiedlichen Lotdicken zwischen den Anschlüssen 4-1, 4-2 und den metallischen Flächen 3-1, 3-2 führen dazu, dass die Hauptabstrahlrichtung der LED 4 zu dem Reflektor 2 geneigt ist, ohne dass dies zu einer Abschattung - wie in Fig. 2 dargestellt - führt.

Die Fig. 1 bis 4 zeigen einen Kraftfahrzeug-Scheinwerfer 1 mit einer Reflektoroptik, wobei anzumerken ist, dass dem Reflektor in dem Fachmann bekannter Weise auch ein Linsensystem zugeordnet sein kann, dass zumindest eine Linse enthält.

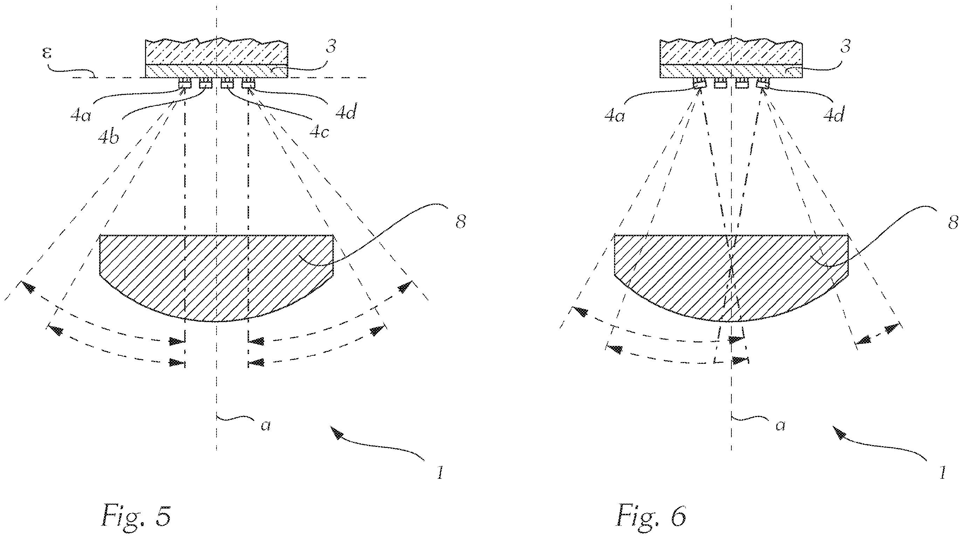

Im Folgenden soll an Hand eines Beispiels gezeigt werden, dass die Erfindung auch auf einen Scheinwerfer angewendet werden kann, dessen Optik von einem Linsensystem gebildet ist. Gleiche oder gleichartige Teile sind dabei mit gleichen Bezugszeichen, wie oben verwendet, bezeichnet. **Fig. 5** zeigt eine optische Anordnung bei einem Scheinwerfer 1, bestehend aus vier LEDs **4a**, **4b**, **4c**, **4d** auf einer Leiterplatte 3 und aus einer Linse **8**. Die LEDs 4a, 4b, 4c, 4d liegen in einer Ebene ε senkrecht zur optischen Achse **a** und sie liegen in unterschiedlichen Abständen von der optischen Achse. Bei den Leuchtdioden 4a, 4d mit dem größten Abstand zur optischen Achse treffen Strahlen, die in einem Winkelbereich bis beispielsweise maximal 30°, gemessen von der Hauptabstrahlrichtung der jeweiligen LED, in die der optischen Achse (dem Zentrum der Linse) abgewandte Halbebene abgestrahlt werden, auf die Lichteintrittsfläche der Linse 8 auf. In der betrachteten Ebene liegen einerseits die Lichtquellen, genauer gesagt die Mittelpunkte der Lichtemissionsflächen der LEDs und andererseits die optische Achse a. Es ist offensichtlich, dass bei dieser Anordnung ein Teil des von den äußeren LEDs 4a, 4d abgestrahlten Lichts verloren geht.

**Fig. 6** zeigt eine vergleichbare Anordnung, bei der die von der optischen Achse a am weitesten beabstandeten LEDs bezüglich der Ebene der Leiterplatte 3 geneigt montiert sind, so dass die Hauptabstrahlrichtung dieser LEDs in Richtung des Zentrums der Linse 8 geneigt wird. Strahlen, die bis zu einem Winkel von beispielsweise 40°, gemessen von der Hauptabstrahlrichtung der LED ,in die Halbebene, die der optischen Achse abgewandt ist, abgestrahlt werden, treffen bei Montage der LEDs mit dieser Orientierung der Lichtemissionsflächen der LEDs auf die Lichteintrittsfläche der Linse 8 auf.

Wenn auch nicht im Detail gezeigt, sollte es für den Fachmann klar sein, dass die beschrieben Neigung der äußeren LEDs in gleicher Weise erzielt wird, wie bei der genauer beschriebenen Ausführung der Fig. 4a und b, nämlich dadurch, dass zur gezielten Einstellung der Abstrahlrichtung der LEDs 4a, 4d diese mit unterschiedlichen Lotdicken zwischen ihren Anschlüssen und den metallischen Flächen der Leiterplatte aufgelötet sind. Es sollte weiters klar sein, dass bei anderen Anzahlen von LEDs die Erfindung ebenso angewendet werden kann, beispielsweise bei drei LEDs in Zusammenhang mit Fig. 6, wobei eine LED zentral in der optischen Achse liegt. Ebenso sind konzentrische LED Anordnungen möglich.

Unter dem Begriff "LED" soll im Rahmen der Erfindung ganz allgemein ein lichtabstrahlendes SMD-Element verstanden werden, beispielsweise auch sogenannte Multichip-LEDs, die mehrere lichtabstrahlende Flächen ausweisen, blaue LEDs in Verbindung mit einem Leuchtstoff, die ein "weißes" Mischlicht abstrahlen etc.

Wenngleich vorstehend nur zwei Anschlüsse einer LED gezeigt wurden, die mit unterschiedlichen Lotdicken aufgelötet sind, sollte es klar sein, dass die Erfindung in gleicher Weise lichtabstrahlende SMD-Elemente mit drei oder mehr Anschlüssen umfasst, solange durch entsprechende Lötdicken die gewünschte Neigung der LEDs sichergestellt ist.

**Liste der Bezugszeichen**

| | | | |
|---|---|---|---|
| 1 | Scheinwerfer | a | optische Achse |
| 2 | Optik, Reflektor | b | Bereich |
| 2f | Reflektor-Innenfläche | d1 | Lotdicke |
| 3 | Leiterplatte | d2 | Lotdicke |
| 3-1 | metallische Fläche von 3 | S | Parabelscheitel |
| 3-2 | metallische Fläche von 3 | α | Gesamtabstrahl-Winkel |
| 4 | LED, SMD-LED | β | Winkel |
| 4 a-d | LED | ε | Ebene |
| 4-1 | Anschluss von 4 | σ | Schnittebene |
| 4-2 | Anschluss von 4 | | |
| 5 | Kühlkörper | | |
| 6-1 | Lot | | |
| 6-2 | Lot | | |
| 7 | Lötstopplack | | |
| 8 | Linse | | |

## Patentansprüche

1. Verfahren zur gezielten Einstellung der Abstrahlrichtung zumindest einer LED (4) bei einem Kraftfahrzeug-Scheinwerfer (1), mit zumindest einer auf metallischen Flächen (3-1, 3-2) einer Leiterplatte (3) mit ihren Anschlüssen (4-1, 4-2) als SMD aufgelöteten LED (4), wobei die metallischen Flächen von Lötstopplack (7) freigestellt sind, sowie mit einer Optik, welche das von der zumindest einen LED abgestrahlte Licht in den Verkehrsraum abstrahlt,
wobei das Verfahren einen Schritt des Aufdruckens einer Menge an Lot und einen Reflow-Prozess-Schritt beinhaltet, **dadurch gekennzeichnet, dass**
zur gezielten Einstellung der Abstrahlrichtung der zumindest einen LED (4) diese mit unterschiedlichen Lotdicken (d1, d2) zwischen ihren Anschlüssen (4-1, 4-2) und den metallischen Flächen (3-1, 3-2) der Leiterplatte (3) aufgelötet wird, wobei auf der Leiterplatte vor dem Reflow-Prozess bei jener metallischen Fläche (3-1), welche zu einem Anschluss (4-1, 4-2) mit größerer Lotdicke gehört, eine solche, sich auch auf dem Lötstopplack (7) erstreckende Menge an Lot (6-1) aufgedruckt wird, dass sich nach dem Sammeln des Lots auf der freigestellten metallischen Fläche eine Höhe des Lötspalts (d1) einstellt, die größer ist als bei der metallischen Fläche (3-2) mit geringerer Lotdicke.

2. Verfahren nach Anspruch 1, **dadurch gekennzeichnet, dass** die Optik als Linsensystem ausgebildet ist, das zumindest eine Linse (8) aufweist und eine Leiterplatte (3) mit zumindest zwei LEDs (4a, 4b, 4c, 4d) in Abstand von der Linse annähernd normal zur optischen Achse (a) angeordnet werden, wobei außerhalb der optischen Achse liegende LEDs (4a, 4d) mit unterschiedlichen Lotdicken zwischen ihren Anschlüssen und den metallischen Flächen der Leiterplatte so angeordnet werden, dass ihre Hauptabstrahlrichtung zu einem Punkt auf der optischen Achse der Linse gerichtet wird.

3. Verfahren nach Anspruch 1, **dadurch gekennzeichnet, dass** die Optik als Reflektoroptik ausgebildet ist und einen Halbschalen-Reflektor (2) aufweist, wobei die Leiterplatte (3) mit der zumindest einen LED (4) im Wesentlichen in der Schnittebene (σ), welche auch die optische Achse enthält, liegt, wobei die zumindest eine LED mit unterschiedlichen Lotdicken (d1, d2) zwischen ihren Anschlüssen (4-1, 4-2) und den metallischen Flächen (3-1, 3-2) der Leiterplatte so angeordnet wird, dass ihre Hauptabstrahlrichtung zu dem Reflektor (2) geneigt ist.

4. Verfahren nach Anspruch 3, **dadurch gekennzeichnet, dass** der Reflektor ein Paraboloid-Halbschalen-Reflektor (2) ist.

5. Verfahren nach Anspruch 3 oder 4, **dadurch gekennzeichnet, dass** dem Reflektor zusätzlich ein Linsensystem mit zumindest einer Linse zugeordnet wird.

## Claims

1. Method for the specific adjustment of the direction of emission of at least one LED (4) in a motor vehicle headlight (1), having at least one LED (4) soldered as SMD on metallic surfaces (3-1, 3-2) of a printed circuit board (3) with its terminals (4-1, 4-2), wherein the metallic surfaces are exposed from solder resist (7), and with optics which emit the light emitted by the at least one LED into the traffic space, the method including a step of printing a quantity of solder and a reflow process step,
**characterised in that**
for the specific adjustment of the radiation direction of the at least one LED (4), the latter is soldered with different solder thicknesses (d1, d2) between its terminals (4-1, 4-2) and the metallic surfaces (3-1, 3-2) of the printed circuit board (3), wherein, prior to the reflow process, the metallic surface (3-1) which leads to a terminal (4-1, 4-2) with a greater solder thickness, such a quantity of solder (6-1) is printed on the solder resist (7), which also extends on the solder resist (7), that after collecting the solder on the exposed metallic surface a height of the solder gap (d1) is obtained which is greater than that of the metallic surface (3-2) with a smaller solder thickness.

2. Method according to claim 1, **characterized in that** the optic is designed as a lens system which has at least one lens (8) and a printed circuit board (3) with at least two LEDs (4a, 4b, 4c, 4d) are arranged at a distance from the lens approximately normal to the optical axis (a), wherein LEDs (4a, 4d) lying outside the optical axis and having different solder thicknesses are arranged between their terminals and the metallic surfaces of the printed circuit board in such a way that their main radiation direction is directed to a point on the optical axis of the lens.

3. Method according to claim 1, **characterized in that** the optics are designed as reflector optics and have a half-shell reflector (2), the printed circuit board (3) with the at least one LED (4) lying essentially in the sectional plane () which also contains the optical axis, the at least one LED with different solder thicknesses (d1, d2) being arranged between its terminals (4-1, 4-2) and the metallic surfaces (3-1, 3-2) of the printed circuit board in such a way that its main radiation direction is inclined towards the reflector (2).

4. Method according to claim 3, **characterized in that** the reflector is a paraboloid half-shell reflector (2).

5. Method according to claim 3 or 4, **characterized in that** the reflector is additionally associated with a lens system having at least one lens.

## Revendications

1. Procédé pour le réglage ciblé de la direction d'émission d'au moins une DEL (4) dans un phare de véhicule automobile (1), avec au moins une DEL (4) soudée en tant que SMD sur des surfaces métalliques (3-1, 3-2) d'une carte de circuit imprimé (3) avec ses bornes (4-1, 4-2), dans lequel les surfaces métalliques sont exposées à partir d'une réserve de soudure (7), et avec des optiques qui émettent la lumière émise par la au moins une LED dans l'espace de circulation, le procédé comprenant une étape d'impression d'une quantité de soudure et une étape de processus de refusion,
**caractérisé en ce que**
pour le réglage sélectif de la direction de rayonnement de la au moins une DEL (4), cette dernière est soudée avec des épaisseurs de soudure différentes (d1, d2) entre ses bornes (4-1, 4-2) et les surfaces métalliques (3-1, 3-2) de la carte de circuit imprimé (3), dans laquelle, avant le processus de refusion, la surface métallique (3-1) qui devient une borne (4-1), 4-2) avec une plus grande épaisseur de soudure, une telle quantité de soudure (6-1) est imprimée sur la réserve de soudure (7), qui s'étend également sur la réserve de soudure (7), qu'après avoir recueilli la soudure sur la surface métallique exposée, on obtient une hauteur de la fente de soudure (d1) qui est supérieure à celle de la surface métallique (3-2) avec une plus petite épaisseur de soudure.

2. Procédé selon la revendication 1, **caractérisé en ce que** l'optique est conçue comme un système de lentilles qui présente au moins une lentille (8) et une carte de circuit imprimé (3) avec au moins deux DEL (4a, 4b, 4c, 4d) sont disposées à une distance de la lentille approximativement perpendiculaire à l'axe optique (a), dans lequel des DEL (4a, 4d) situées en dehors de l'axe optique et présentant des épaisseurs de soudure différentes sont disposées entre leurs bornes et les surfaces métalliques de la carte de circuit imprimé de telle sorte que leur direction de rayonnement principale est dirigée vers un point sur l'axe optique de la lentille.

3. Procédé selon la revendication 1, **caractérisé en ce que** l'optique est réalisée sous forme d'optique à réflecteur et présente un réflecteur en demi-coque (2), la carte de circuit imprimé (3) avec la au moins une LED (4) se trouvant essentiellement dans le plan de coupe () qui contient également l'axe optique, la au moins une LED avec différentes épaisseurs de soudure (d1, d2) étant disposée entre ses bornes (4-1, 4-2) et les surfaces métalliques (3-1, 3-2) de la carte de circuit imprimé de telle sorte que sa direction de rayonnement principale est inclinée vers le réflecteur (2).

4. Procédé selon la revendication 3, **caractérisée en ce que** le réflecteur est un réflecteur paraboloïde à demi-coquille (2).

5. Procédé selon la revendication 3 ou 4, **caractérisé en ce que** le réflecteur est en outre associé à un système de lentilles ayant au moins une lentille.
